# EUROPEAN PATENT APPLICATION

(11) **EP 1 365 636 A1**
(43) Date of publication of application: **26.11.2003**
(21) Application number: 02700782.2
(22) Date of filing: 26.02.2002
(51) Int. Cl.: H05G 2/00

(54) **EXTREME ULTRAVIOLET GENERATING DEVICE, EXPOSURE DEVICE USING THE GENERATING DEVICE, AND SEMICONDUCTOR MANUFACTURING METHOD**

(30) Priority: 26.02.2001 JP 2001049728
(71) Applicant: Nikon Corporation, Tokyo 100-8331 (JP)
(72) Inventor: KANDAKA, Noriaki, c/o NIKON CORPORATION, Tokyo 100-8331 (JP)
(74) Representative: Viering, Jentschura & Partner
(86) International application number: JP0201714
(87) International publication number: WO02069677

(57) **Abstract**

An extreme ultraviolet light generating device 1 arranged at the uppermost of an X-ray exposure apparatus is provided with a vacuum chamber 4, in which a central discharge electrode 2 and a peripheral discharge electrode 3 are arranged coaxially with each other. The central discharge electrode 2 is formed of tungsten, and a hollow portion 2a thereof is coated with a diamond thin film 10 having a thickness of 0.2 mm. In the hollow portion 2a, the distal end of a cooling water pipe 11 connected to a cooling water supplying device 12 is arranged. The temperature of the cooling water is always kept at about 20 degree C and supplied to the hollow portion 2c of the central discharge electrode 2 through the cooling pipe 11. As the result, the temperature of the central discharge electrode 2 is quickly decreased resulting in preventing the rising of the temperature of the central discharge electrode 2, therefore to reduce the amount of the debris.

## Description

### Field of the Invention

The present invention relates to an extreme ultraviolet light generating device used for an X-ray projection exposure apparatus, an exposure apparatus using the extreme ultraviolet light generating device and a semiconductor manufacturing method. More specifically, the present invention relates to an extreme ultraviolet light generating device capable of reducing an amount of debris, which is generated due to melting and evaporation of an electrode material. And, it relates to an exposure apparatus using the extreme ultraviolet light generating device and a semiconductor manufacturing method.

### Background of the Invention

For manufacturing semiconductor integrated circuits, a demagnification projection method for transferring a very fine pattern formed on a mask onto a wafer coated with a resist by using a visible light or an ultraviolet light is generally adopted. But, since size of the pattern approaches to the diffraction limit, it becomes theoretically difficult to transfer the finer pattern by such demagnification projection method using a visible light or an ultraviolet light. Therefore, for transferring such finer pattern, a demagnification projection exposure techniques (an EUV lithography techniques) using an extreme ultraviolet light (hereinafter referred to as an EUV light) having a wavelength of about 11 nm to 13 nm shorter than a wavelength of the ultraviolet light has been developed.

A light having a wavelength within a range of the EUV light is strongly absorbed in all substances. So, refractive type optical elements such as lenses may not be used for a projection optical system and a reflective optical elements are adopted for the projection optical system. In addition, since a reflectivity of a generally used reflective mirror is very low, a reflective surface of the reflective optical elements should have a multi-layer film structure (hereinafter referred to as an EUV multi-layer film mirror). The EUV multi-layer film structure allows high reflectivity of the EUV light having a wavelength used for the projection of the EUV lithography.

At present , it is known that a multi-layer film formed of molybdenum (Mo) and silicon (Si) or a multi-layer film formed of molybdenum (Mo) and beryllium (Be) can achieve a reflectivity close to 70 %. So, it is proposed that one of the above-mentioned multi-layer films is available for the reflective mirrors used for the EUV lithography technique. The Mo/Si multi-layer film provides a high reflectivity at a wavelength around 13 nm, and the Mo/Be multi-layer film provides a high reflectivity at a wavelength around 11 nm. Accordingly, a light source used for the EUV lithography technique is required to radiate an electromagnetic wave having a wavelength of about 11 nm to 13 nm.

As such a light source used for the EUV lithography technique, a laser produced plasma light source or a discharge plasma light source (a dense focus plasma light source) using a plasma pinch are proposed.

The laser produced plasma light source utilizes an EUV light radiated from a high-temperature plasma, which is generated by focusing a pulse laser beam onto a target material (solid, liquid or gas) to excite the target material into plasma state.

One example of the dense focus plasma light source is disclosed in Japanese Laid Open Patent Publication No. Hei 10-319195.

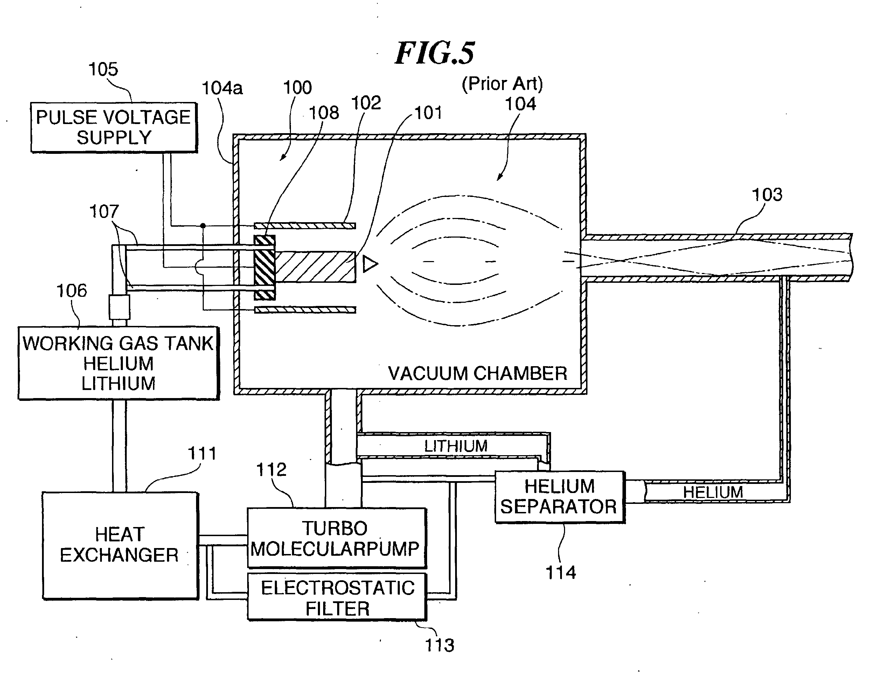

Fig. 5 is a drawing schematically showing a structure of an example of the dense focus plasma light source as disclosed in the above Patent Application.

A plasma pinch unit 100 is shown in Fig.5. The plasma pinch unit 100 is provided with a condenser 104 and a light pipe 103. In the plasma pinch unit 100, a central electrode 101 and a cylinder-shaped peripheral electrode 102 which surrounds the central electrode 101 are arranged. The central electrode 101 is insulated with the peripheral electrode 102 by an insulator 108. To each base of the electrodes 101 and 102, a pulse power supply 105 as a plasma pinch source is connected. On applying a high pulse voltage from the pulse power supply 105, a discharge is generated between the electrodes 101 and 102. To each base of the electrodes 101 and 102, a gas pipe 107 fed from a gas tank 106 is also connected. In the gas tank 106, a working gas mixture of an active gas such as lithium, which causes a desirable transition by the discharge generated between the electrodes 101 and 102, and helium buffer gas is filled. The gas tank 106 is connected to a system provided with a heat exchanger 111, a turbo molecular pump 112, an electrostatic filter 113, a helium separator 114 and the like.

When high pulse voltage from the pulse power supply 105 is applied to the electrodes 101 and 102, a discharge is generated between the electrodes 101 and 102. At the beginning of the discharge, a creeping discharge is observed around the base of the electrodes 101 and 102. The creeping discharge ionizes the working gas introduced from the gas tank 106 to generate an initial plasma. Once the plasma is generated, electrons and ions in the plasma move by an electric gradient caused by electric potential difference between the electrodes 101 and 102, thus a current flow is generated in the plasma. The electrons and ions in the plasma are directed and concentrated to a distal end of the central electrode 101 due to an interaction with the magnetic field produced by the current flow. As the result, at the distal end of the central electrode 101, a high-temperature and high-density plasma is generated, which radiates an electromagnetic wave including the EUV light.

The substance forming the plasma is mainly working gas excited by the focused plasma. And, from the plasma, an electromagnetic wave having a wavelength corresponding to the ion transition of the working gas and the electrode material is radiated. A region from which the EUV light is radiated is almost included in a spherical area having a diameter of 1 mm. The radiation from the plasma lasts for about 0.1 to about 1 microseconds. When the working gas includes a lithium vapor, a line spectrum showing a EUV light having a wavelength of 13.5 nm, which corresponds to the transition of lithium ion, is obtained. It is reported that the quantity of the EUV light radiated by one discharge of the dense focus plasma light source exceeds the quantity of the EUV light radiated by a laser produced plasma light source. According to the report, the dense focus plasma light source is able to be powered at a high pulse repetition frequency of several kHz.

The EUV light, which is absorbed in almost substance as mentioned above, is absorbed in a small contamination adhered to the reflective surface of the EUV multi-layer film reflective mirror. Thus a reflectivity of the mirror is lowered. Accordingly, it is required to prevent the adhesion of contamination to the reflective surface of the EUV multi-layer film reflective mirror as much as possible. In the dense focus plasma light source, debris sputtered from the electrode at plasma generation causes the contamination for the reflective surface. As described in detail, when a very high-temperature plasma is generated, a part of the electrode is heated rapidly resulting in the part thereof being melted or evaporated. The melted or evaporated debris are sputtered in the circumference of the electrode by the impact at the plasma generation. If the EUV multi-layer film mirror is arranged near the electrode, the debris are adhered to the reflective surface of the mirror, thus the performance of the optical system is reduced.

In the EUV lithography, it is required that a large quantity of light may be radiated in a unit time and that the light source can be powered at a high repetition frequency in order to obtain a sufficient processing speed (throughput). And, the EUV lithography has been developed so as to be able to expose a wide region while relatively scanning a EUV reflective mask, on which a pattern to be transferred is formed, and a wafer, on which the pattern will be exposed, using an arc-shaped irradiating area (the length thereof is about 30mm, and the width thereof is about 2 mm) capable of obtaining a high resolving power. Accordingly, it is preferable that the pulse light source such as the laser produced plasma light source and the dense focus plasma light source has a repetition frequency as high as possible in order to keep uniform exposure.

By such reasons, the repetition frequency at which the plasma is generated requires an order of kHz. However, a plasma generated at such high repetition frequency enhances the heating of the electrode, then the amount of the debris is increased due to rising of temperature and enlarging of the melted part. Accordingly, a dense focus plasma light source or a method capable of preventing remarkable increasing of the amount of the debris has been required even if the repetition frequency at which the plasma is generated becomes high. In addition, by using such dense focus plasma light source, a semiconductor manufacturing method for stably manufacturing semiconductors for long term is required.

The present invention has been developed in view of the above problems, and it is an object of the present invention to provide an extreme ultraviolet light generating device capable of radiating an extreme ultraviolet light efficiently and preventing increasing of the amount of the debris sputtered due to melting and evaporation of the electrode. And, it is also an object to provide an exposure apparatus using the extreme ultraviolet light generating device. And, it is also an object to provide a semiconductor manufacturing method for stably manufacturing semiconductors for long term.

### Summary of the Invention

In order to solve the above-mentioned problems, an extreme ultraviolet light generating device according to the present invention comprises: a vacuum chamber having an evacuating means; a pair of discharge electrodes disposed in said chamber; a power supply for applying a high pulse voltage between said electrodes, and a gas supplying means for supplying a working gas to between said discharge electrodes: wherein discharge portion is localized and said working gas supplied is exited at said discharge portion to a high-temperature and high-density plasma and an extreme ultraviolet light corresponding to a transition energy of specific ion in said working gas is radiated from said plasma; said extreme ultraviolet light generating device further comprises a cooling means for liquid-cooling said discharge electrodes.

In the present invention, since the discharge electrode is cooled by the cooling means so that the temperature thereof may not rise, the melting and evaporation of the discharge electrode is prevented thus resulting in reducing the amount of debris.

In the present invention, it is preferable that a cooling water flow passage is formed in said discharge electrodes, and an inner wall of said flow passage is coated with a thin film of insulator and a high heat-conductivity.

In this case, a diamond thin film may be used for the thin film as an insulator and having a high heat-conductivity. Since the diamond is insulator, current does not flow toward the discharge electrode while applying voltage to the discharge electrodes. And, since the diamond has a high heat-conductivity, heat produced at the discharge electrode can be transferred to the cooling water flow passage efficiently.

In the present invention, it is further preferable that a part of discharge electrode closer to said discharge portion is formed by a porous metal, said part of discharge electrode closer to said discharge portion is provided with a means for supplying and permeating liquid, and said evacuating means of said vacuum chamber has a sufficient evacuating ability for maintaining a pressure enough low for an extreme ultraviolet light to transmit.

In this case, if the generated plasma is concentrated into the distal end of the discharge electrode, the liquid oozed onto the surface of the discharge electrode formed of the porous metal is evaporated and made into a plasma thus radiating a electromagnetic wave. And, heat of vaporization as this liquid evaporates cools the discharge electrodes. Since the evaporated liquid is evacuated by the evacuating means having a sufficient evacuating ability, the pressure in the vacuum chamber can be maintained at a pressure capable of transmitting the soft X-ray.

As the porous metal, tungsten or tantalum having a porosity of 10 to 40 % may be used.

Further, it is preferable that a part of discharge electrode closer to said discharge portion is formed by a porous ceramics, said part of discharge electrode closer to said discharge portion is provided with a means for supplying and permeating electrolyte liquid, and said evacuating means for evacuating said vacuum chamber has a sufficient evacuating ability for maintaining a pressure enough low for an extreme ultraviolet light to transmit.

In this case, the part of discharge electrode is made by the porous ceramics into which an electrolytic solution permeates, the porous ceramics having no electrical conductivity itself. Since the melting point of the ceramics is higher than that of metal, the amount of the debris can be reduced. And, since the plasma which radiates an electromagnetic wave is formed of the electrolyte solution oozed from the ceramics, the EUV light having a wavelength of about 13 nm can be accurately radiated.

And, for the porous ceramics, alumina and silicon carbide having a porosity of 10 to 40 % may be used.

Further, it is possible that said liquid is water, and said specific ion is oxygen in said water.

In this case, the water oozed from the discharge electrode formed of the porous metal is evaporated and transformed into a plasma. When oxygen atom forming the water is transformed into a plasma, the EUV light having a wavelength of 13 nm is radiated, the wavelength being corresponding to the transition of 5-valent ion (O⁵⁺ : 4d→2p). And, the heat of vaporization of the water prevents the rising of the temperature of the discharge electrode thus resulting in reducing the amount of the debris. And, inside of the vacuum chamber is evacuated, and the water is always permeated into the discharge electrode by the capillarity of water. As the result, it is possible for the light generating device to be powered repetitively.

Further, it is preferable that the extreme ultraviolet light generating device according to claim comprises a cooling means for cooling said liquid or said electrolyte liquid.

By using this cooling means, the temperature rise of the discharge electrode can be suppressed thus resulting in reducing the amount of the debris. The cooling means may cool the liquid or electrolyte liquid to about 20 degree C.

An exposure apparatus according to the present invention comprises the above-mentioned extreme ultraviolet light generating device, an irradiating optical system for irradiating said extreme ultraviolet light onto a mask, and a projection optical system for projecting an light reflected from said mask onto a wafer.

In the exposure apparatus, the extreme ultraviolet light can be stably used for exposure for a long term.

A semiconductor manufacturing method according to the present invention comprises a lithography process using the above-mentioned exposure apparatus.

In the semiconductor manufacturing method, semiconductor elements can be manufactured stably and efficiently for a long term.

### Brief Description of the Drawings

Fig.1 is a drawing showing a whole structure of an X-ray exposure apparatus according to one embodiment of the present invention.
Fig.2 is an enlarged drawing showing a part of the extreme ultraviolet light generating device of the X-ray exposure apparatus of Fig. 1.
Fig.3 is a drawing showing another embodiment of the extreme ultraviolet generating device of an X-ray exposure apparatus according to the present invention.
Fig.4 is a flowchart showing the manufacturing method for manufacturing a micro device (for instance, a semiconductor chip such as IC and LSI, a liquid crystal panel, a CCD, a thin film magnetic head and micro-machine).
Fig. 5 is a drawing schematically showing a structure of the dense focus plasma light source as disclosed in Japanese Laid Open Patent Publication No. Hei 10-319195.

### Detailed Description of Embodiment of the Invention

The preferred embodiments of the present invention will be described in detail with reference to the accompanying drawings.

First, an outline of an X-ray demagnification projection exposure apparatus will be explained.

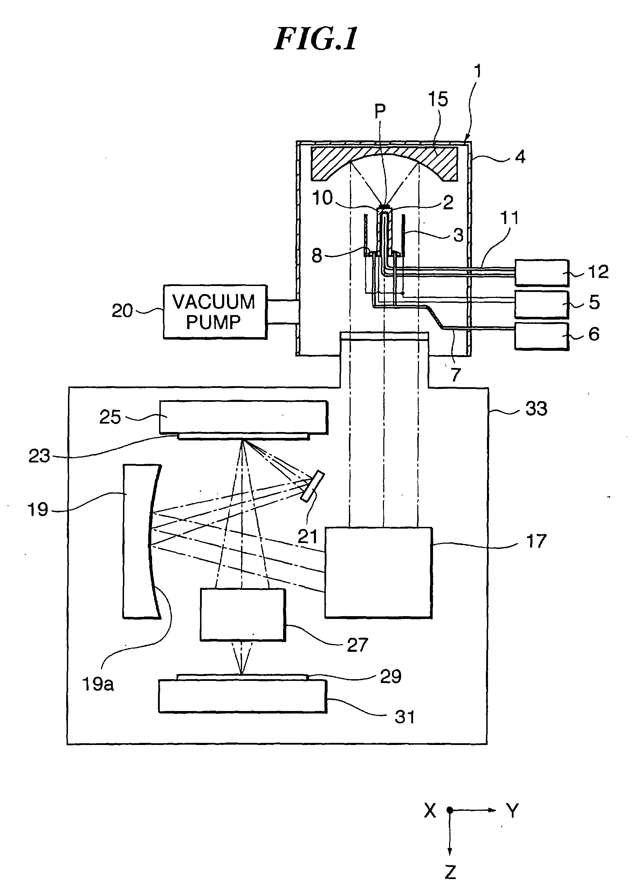

Fig.1 is a drawing showing a whole structure of an X-ray exposure apparatus according to one embodiment of the present invention.

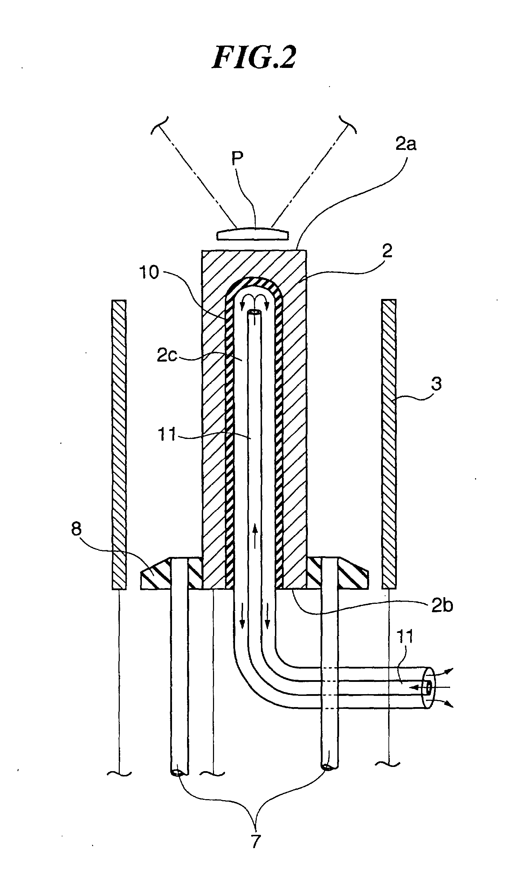

Fig.2 is an enlarged drawing showing a part of the extreme ultraviolet light generating device of the X-ray exposure apparatus of Fig.1.

The X-ray exposure apparatus as shown in these figures performs a step and scan type exposure by using a soft X-ray (an EUV light) having a wavelength around 13 nm.

At the uppermost of the X-ray exposure apparatus as shown in Fig. 1, an extreme ultraviolet generating device 1 is arranged. The extreme ultraviolet generating device 1 is provided with a vacuum chamber 4, which is connected to a vacuum pump (an evacuating means) 20. The vacuum pump 20 evacuates the inside of the vacuum chamber 4 at 10 Pa or less.

In the vacuum chamber 4, a hollow pipe shaped central discharge electrode 2 and a cylinder shaped peripheral discharge electrode 3 which surrounds the central electrode 2 are disposed coaxially with each other. As enlargedly shown in Fig.2, the central discharge electrode 2 is insulated with the peripheral discharge electrode 3 by an insulator 8. The central discharge electrode 2 is formed of tungsten having a high-melting point (the melting point is 3387 degree C.) The distal end 2a of the central discharge electrode 2 is closed, and the base end 2b thereof is open. An inner wall of a hollow portion (a passage for cooling water) 2c of the central discharge electrode 2 is coated with a diamond thin film 10 having a thickness of about 0.2 mm. The diamond thin film 10 electrically insulates the inner wall of the hollow portion 2c of the central discharge electrode 2.

In the hollow portion 2c of the central discharge electrode 2, a distal end of a cooling water pipe 11 is arranged, which is a circulating flow passage connected to a cooling water supply 12. The temperature of the cooling water in the cooling water supply 12 is always kept to 20 degree C. The central discharge electrode 2 is thermally connected to the cooling water pipe 11, while being electrically insulated with the cooling water pipe 11 by the diamond thin film 10. The discharge electrodes 2 and 3 are connected to a high pulse voltage applying device 5, which applies a high pulse voltage of about 1 kV between both electrodes 2 and 3. And, a working gas supplying device 6 is connected to the discharge electrodes 2 and 3 via a gas pipe 7. In the working gas supplying device 6, a gas mixture (a working gas) of a lithium vapor and helium is filled.

When the working gas is supplied through the gas pip 7 from the working gas supplying device 6 and a high pulse voltage is applied from the high pulse voltage applying device 5, a high-temperature and high-density plasma P is generated at the distal end 2a of the central discharge electrode 2. The repetition frequency at which the plasma is generated is about 1 kHz. By generating the plasma, the lithium in the working gas radiates an EUV light having a wavelength around 13 nm. Such plasma generating process is described in Japanese Laid Open Patent Publication No. Hei 10-319195 in more detail.

The surface of the central discharge electrode 2 is heated by the high temperature plasma P at the high repetition frequency. As the result, the distal end 2a of the central discharge electrode 2, where the high-temperature and high-density plasma P is generated, is overheated to a very high temperature (for instance, 2000 degree C). In this extreme ultraviolet generating device, since the hollow portion 2c of the central discharge electrode 2 is supplied with the cooling water through the cooling water pipe 11 from the cooling water supply 12, the temperature of the central discharge electrode 2 quickly falls thus preventing the temperature of the central discharge electrode 2 from further rising. And, since the diamond thin film 10 arranged between the central discharge electrode 2 and the cooling water pipe 11 is insulator, a current does not flow toward the cooling water pipe 11 when a voltage of about 1 kV is applied to the central discharge electrode 2. At the same time, the heat produced at the central discharge electrode 2 is efficiently transmitted to the cooling water pipe 11 since the diamond has a high heat-conductivity. By cooling the central discharge electrode 2 by above-mentioned ways, melting and evaporation of the central discharge electrode 2 is prevented thereby to reduce the amount of debris.

Incidentally, while the hollow portion 2c of the central electrode 2 is cooled by supplying the cooling water in this embodiment, it is possible to cool the hollow portion 2c by using the methods as shown in the following (1) and (2).
(1) The central discharge electrode 2 is formed of a solid type, and an insulator such as a diamond is arranged at the rear end of the central discharge electrode 2. So, the central discharge electrode 2 is cooled through the insulator.
(2) The central discharge electrode 2 is cooled by using a cooling means, such as a Peltier element, free of a mechanical operation.

The entire construction of the X-ray exposure apparatus will be explained by referring to Fig.1.

In the vacuum chamber 4, a rotation symmetrical parabolic reflective mirror 15 is arranged at the upper of the discharge electrodes 2 and 3. The concave reflective surface of the rotation symmetrical parabolic reflective mirror 15 is coated with a Mo/Si multi-layer film. The multi-layer film allows only the EUV light having a wavelength of 13 nm among the all EUV light, which is radiated by the generating of the plasma and incident on the rotation symmetrical parabolic reflective mirror 15, to collimate the EUV light and reflect it downward of the extreme ultraviolet generating device 1.

Under the extreme ultraviolet generating device 1, an exposure chamber 33 is arranged, in which an irradiating optical system 17 comprising of condenser type reflective mirrors, fly eye type reflective mirrors and the like is provided. The irradiating optical system 17 shapes the EUV light reflected at the rotation symmetrical parabolic reflective mirror 15 into an arc-shaped light beam, and reflects it toward the left of the figure.

At the left of the irradiating optical system 17 in the figure, an EUV light reflective mirror 19 is arranged. The EUV light reflective mirror 19 has a circular concave reflective surface 19a shown in the right in the figure, and is supported vertically by unshown supporting member. At the right of the EUV light reflective mirror 19 in the figure, an optical pass changing reflective mirror 21 is obliquely arranged. Over the optical pass changing reflective mirror 21, a reflective mask 23 is horizontally arranged such that the reflective surface thereof directs downward. The EUV light emitted from the irradiating optical system 17 is reflected and is focused by the EUV reflective mirror 19, and then reaches to the reflective surface of the reflective mask 23 via the optical pass changing reflective mirror 21.

The reflective surfaces of the mirrors 19 and 21 are formed of quartz precisely worked. The reflective surface 19a is coated with a Mo/Si multi-layer film having a high reflectivity for the EUV light having a wavelength of 13 nm, as well as the reflective surface of the rotation symmetrical parabolic reflective mirror 15. Incidentally, in the case which a X-ray having a wavelength of 10 to 15 nm is used, the multi-layer film may be a multi-layer film formed of a material such as Ru (Ruthenium) and Rh (Rhodium), and another material such as Si, Be (Beryllium) and B₄C (4 boride carbon).

The reflective surface of the reflective mask 23 is also coated with a reflective film formed of a multi-layer film. A mask pattern corresponding to a pattern being transferred onto a wafer is formed by the reflective film. The reflective mask 23 is supported to a mask stage 25 as shown in the upper thereof in the figure. The mask stage 25 can move at least in the Y direction, and the EUV light reflected by the optical pass changing reflective mirror 21 is emitted onto the mask 23 successively.

Under the reflective mask 23, a projection optical system 27 and the wafer 29 are arranged in this order. The projection optical system 27 comprising of a plurality of reflective mirrors projects the EUV light reflected by the reflective mask 23 onto the wafer 29 at the predetermined projection magnification (for instance, 1/4). The wafer 29 is chucked onto the wafer stage 31 capable of moving in the X, Y and Z directions.

When an exposure is carried out, the irradiating optical system 17 irradiates the EUV light onto the reflective surface of the reflective mask 23. At this time, the reflective mask 23 and the wafer 29 are relatively scanned relative to the projection optical system 27 at a speed corresponding to the projection magnification of the projection optical system 27. By such action, the entire circuit pattern on the reflective mask 23 is transferred onto a plurality of shot areas of the wafer sequentially by a step and scan method. Incidentally, an IC pattern of a line and space having a width of 0.07 micro meter can be projected onto the resist coated on the wafer to fabricate a chip having a square shape of 25 nm side length.

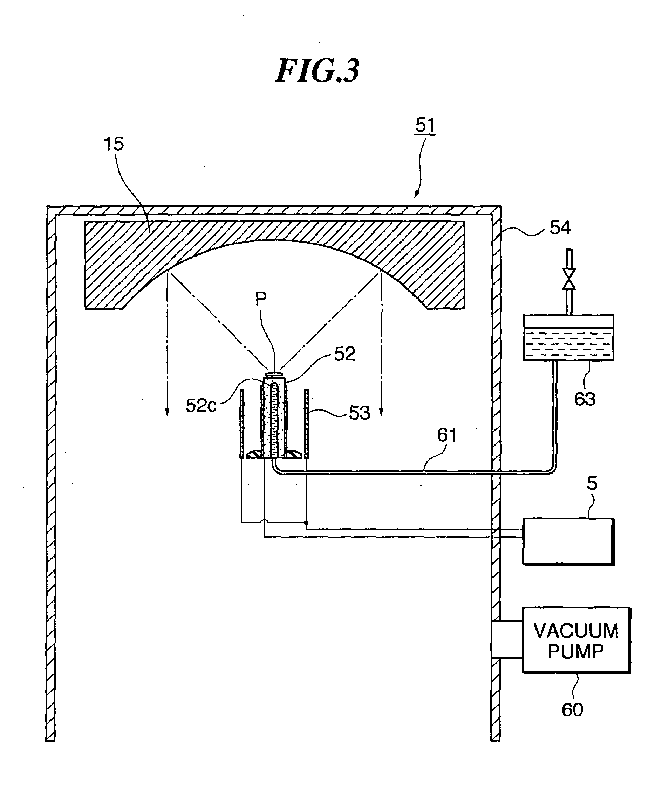

Next, another embodiment of the extreme ultraviolet generating device will be explained referring to Fig. 3.

Fig.3 is a drawing showing another embodiment of the extreme ultraviolet generating device of an X-ray exposure apparatus according to the present invention.

The extreme ultraviolet generating device 51 in this embodiment is provided with a vacuum chamber 54 having a same structure as that of the extreme ultraviolet generating device 1 described above. The vacuum chamber 54 is provided with a vacuum pump (an evacuating means) 60 capable of evacuating at about 10⁻³ Pa (for instance). In the vacuum chamber 54, a hollow pipe shaped central discharge electrode 52 and a cylinder shaped peripheral discharge electrode 53 which surrounds the central electrode 52 are disposed coaxially with each other. The central discharge electrode 52 is insulated with the peripheral discharge electrode 53 by an insulator 8. The central discharge electrode 52 is formed of porous tungsten having a porosity of about 10 to about 40% in this embodiment.

A hollow portion 52c of the central discharge electrode 52 is connected to a tank 63 through a pipe 61. The pipe 61 and the tank 63 are formed of polytetrafluoroethylene (Teflon). The temperature of the water in the tank 63 is always kept to 20 degree C. The water in the tank 63 is supplied to the hollow portion 52 c of the central discharge electrode 52 and permeates to the porous tungsten. To the discharge electrodes 52 and 53, a high pulse voltage applying device 5 having a same structure as that of the extreme ultraviolet generating device 1 is connected. Since the pipe 61 and the tank 63 are formed of polytetrafluoroethylene, a charge supplied to the discharge electrodes 52 and 53 from the high pulse voltage supplying device 5 does not escape.

When helium gas as a buffer gas is introduced in the vacuum chamber 54 and a pulse voltage of about 1 kV is applied from the high pulse voltage applying device 5, a high-temperature and high-density plasma P is generated at the distal end 52c of the central discharge electrode 52. At this time, the water permeated into the central discharge electrode 52 evaporates earlier than tungsten, because the melting point and boiling point of the water is lower than these of tungsten. As the result, a plasma is repetitively generated. Once oxygen atom constituting the water molecule is excited into a plasma state, a line spectrum showing a wavelength of about 13 nm corresponding to a transition of 5-valent ion (O⁵⁺: 4d→2p) is obtained. Since the water supplied to the central discharge electrode 52 is cooled in the tank 63, the rising of temperature of the central discharge electrode 52 is prevented. And, the heat of vaporization as the water evaporates also cools the discharge electrodes thus preventing the rising of the temperature of the central discharge electrode 52. Accordingly, the melting and evaporation of the central discharge electrode 52 is prevented thereby to reduce the amount of the debris.

The water after the generating of the plasma is evacuated by the vacuum pump 60. By such evacuating using the vacuum pump 60, a sufficient low pressure to transmit the EUV light can be kept even if the vaporization of water in the vacuum chamber 54. And, the inside of the vacuum chamber 54 is evacuated, and the water is always permeated into the central discharge electrode 52 by its surface tension. As the result, it is possible for the extreme ultraviolet light generating device to be powered repetitively.

And, the central discharge electrode 52 may be formed of a porous ceramics such as alumina. In this case, for a liquid in the tank 63, an electrolyte liquid having an electrical conductance should be used instead of water. Since the ceramics has a higher melting point than metal, it is possible to prevent the increase of the amount of the debris. And, since the plasma from which an electromagnetic wave is radiated is formed of the electrolyte liquid permeated into the ceramics, the EUV light having a wavelength of about 13 nm can be radiated accurately.

Next, a semiconductor manufacturing method using the above-mentioned X-ray generating apparatus will be explained.

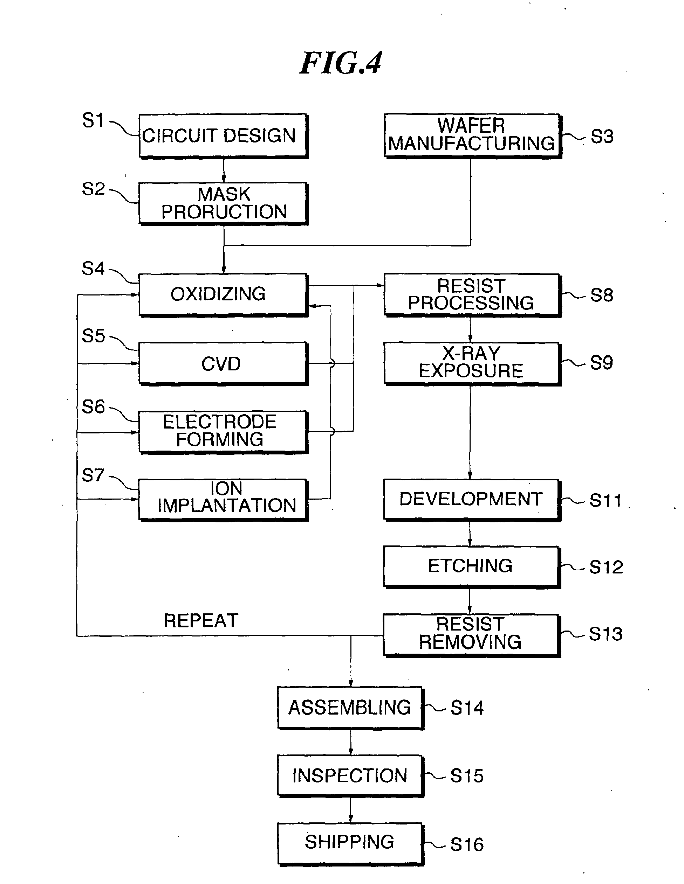

Fig.4 is a flowchart showing the manufacturing method for manufacturing a micro device (for instance, a semiconductor chip such as an IC and an LSI, a liquid crystal panel, a CCD, a thin film magnetic head and micro machine).

In the step S1 (circuit design), a circuit pattern of a semiconductor device is designed.

In the step S2 (mask production), a mask on which the designed pattern is formed is produced. At this time, a correction for a blur caused by an aberration may be carried out by locally resizing the pattern.

And, in the step S3 (wafer manufacturing), a wafer is manufactured by using a suitable material such as silicon.

In the step S4 (oxidizing), the surface of the wafer is oxidized. In the step S5 (CVD), the surface of the wafer is coated with an insulating film. In the step S6 (electrode forming), an electrode is formed on the wafer by vapor deposition. In the step S7 (ion implantation), an ion is implanted into the wafer. In the step S8 (resist processing), a photosensitive material is coated on the wafer.

In the step S9 (X-ray exposure), the circuit pattern on the mask produced in the step 2 is printed on the wafer by using the above-mentioned X-ray exposure apparatus.

In the step S11 (development), the exposed wafer is developed. In the step S12 (etching), the portion except for the resist image is selectively etched. In the step 13 (resist removing), an unnecessary resist after the etching is removed. By repeating the step S4 to the step S13, the circuit pattern is multiply formed on the wafer.

In the step S14 (assembling), which is called for post-processing, the wafer manufactured by the above-mentioned steps is made into a semiconductor chip. The step S14 contains an assembling step (dicing, bonding), a packaging step (chip passivation and the like. In the step S15 (inspection), the semiconductor device manufactured in the step S14 is inspected on the operation and the durability. Through the steps, the semiconductor is completely manufactured and shipped (step S16).

While the above-mentioned embodiments explain an X-ray exposure apparatus using the EUV light having a wavelength of about 13 nm, the present invention does not limited to this. By selection of the type of the working gas, the material forming the discharge electrode, and the type of the liquid which permeates into the electrode, the present invention is possible to apply various wavelength region.

### The applicability on the Industry

As described above, the present invention can provide an extreme ultraviolet generating device capable of reducing the amount of debris sputtered due to melting and evaporation of the electrode, and an exposure apparatus using the same. And, a semiconductor manufacturing method for manufacturing semiconductor elements stably and efficiently for a long time can be provided.

## Claims

1. An extreme ultraviolet light generating device comprising:
a vacuum chamber having an evacuating means;
a pair of discharge electrodes disposed in said chamber;
a power supply for applying a high pulse voltage between said electrodes, and
a gas supplying means for supplying a working gas to between said discharge electrodes:
wherein discharge portion is localized, and said working gas supplied is exited at said discharge portion to a high-temperature and high-density plasma and an extreme ultraviolet light corresponding to a transition energy of specific ion in said working gas is radiated from said plasma;
said extreme ultraviolet light generating device further comprising
a cooling means for liquid-cooling said discharge electrodes.

2. The extreme ultraviolet light generating device according to claim 1,
wherein a cooling water flow passage is formed in said discharge electrodes, and
an inner wall of said flow passage is coated with a thin film of insulator and a high heat-conductivity.

3. The extreme ultraviolet light generating device according to claim 1
wherein a part of discharge electrode closer to said discharge portion is formed by a porous metal,
said part of discharge electrode closer to said discharge portion is provided with a means for supplying and permeating liquid, and
said evacuating means of said vacuum chamber has a sufficient evacuating ability for maintaining a pressure enough low for an extreme ultraviolet light to transmit.

4. The extreme ultraviolet light generating device according to claim 1,
wherein a part of discharge electrode closer to said discharge portion is formed by a porous ceramics,
said part of discharge electrode closer to said discharge portion is provided with a means for supplying and permeating electrolyte liquid, and
said evacuating means for evacuating said vacuum chamber has a sufficient evacuating ability for maintaining a pressure enough low for an extreme ultraviolet light to transmit.

5. The extreme ultraviolet light generating device according to claim 3,
wherein said liquid is water, and said specific ion is oxygen in said water.

6. The extreme ultraviolet light generating device according to claim 3 or 4, further comprising a cooling means for cooling said liquid or said electrolyte liquid.

7. An exposure apparatus comprising:
said extreme ultraviolet light generating device according to one of claim 1 to 6;
an irradiating optical system for irradiating said extreme ultraviolet light onto a mask, and
a projection optical system for projecting a light reflected from said mask onto a wafer.

8. A semiconductor manufacturing method comprising a lithography process using the exposure apparatus according to claim 7.
